# EUROPEAN PATENT APPLICATION

(11) **EP 1 946 833 A1**
(43) Date of publication of application: **23.07.2008**
(21) Application number: 07006228.6
(22) Date of filing: 27.03.2007
(51) Int. Cl.: B01J 21/08, B01J 23/75, B01J 23/755, B01J 35/08, C01B 31/02, D01F 9/12

(54) **Catalyst nanoparticles for obtaining carbon nanotubes**

(30) Priority: 21.12.2006 US 876234 P
(71) Applicant: Interuniversitair Microelektronica Centrum, 3001 Leuven (BE)
(72) Inventor: Esconjauregui, Santiago Cruz, 3001 Leuven (BE); Whelan, Caroline, 5310 Hanret (BE)
(74) Representative: Bird, William Edward

(57) **Abstract**

The present invention provides a method for forming catalyst nanoparticles (5) on a substrate (S) and a method for forming elongate nanostructures (9) on a substrate (S) using the nanoparticles (5) as a catalyst. The methods according to embodiments of the invention may advantageously be used in, for example, semiconductor processing. The methods according to embodiments of the present invention are scalable and fully compatible with existing semiconductor processing technology. Furthermore, the methods according to embodiments of the present invention allow forming catalyst particles (5) and elongate nanostructures (9) at predetermined locations on a substrate (S).

## Description

### Technical field of the invention

The present invention relates to catalyst nanoparticles. More particularly, the present invention provides a method for forming catalyst nanoparticles on a substrate. Furthermore, the present invention provides a method for forming elongate nanostructures on a substrate using the catalyst nanoparticles formed by a method according to embodiments of the invention. The methods according to embodiments of the invention can be used with any size of substrate and are fully compatible with existing semiconductor processing, e.g. for manufacturing nano-devices.

### Background of the invention

Carbon Nanotubes (CNTs) have been identified as one of the most promising candidates to extend and even replace materials currently used in microelectronic manufacturing. Metallic CNTs have been proposed as nano-electronic interconnects due to the high current carrying capacity, whereas semiconducting CNTs have been indicated as nanoscale transistor elements due to their large range band gap. These and similar applications cannot be fully accomplished yet since the fabrication of any CNT-based device still faces a variety of unsolved issues, which vary from one application to another but may, however, be similar in some respects. A first issue is related to the impossibility of synthesizing different CNTs with identical properties. A second issue is the incompatibility of the current growth parameters with realistic batch-type technology integration schemes. A final issue is related to the lack of a scalable method for depositing the catalyst in predefined locations. Furthermore, CNTs must be integrated efficiently and economically into various device architectures. To realize their full potential in various device applications, catalyst placement and selective growth are very important issues.

While the (isolated) growth in a large scale process has been demonstrated for Vertically Aligned Carbon Nanofibres (VACNF), the synthesis of selectively deposited CNTs with control over the properties and placement has been much more limited. Uniform arrays of multiwall CNTs (MWCNTs) and single free-standing aligned MWCNTs were grown by patterning Ni nanoparticles at precise, predetermined locations. Patterning was defined using a combination of optical and electron-beam lithography whereas the growth was achieved by using Plasma Enhanced Chemical Vapor Deposition (PECVD) as described by Teo et al. in "Uniform Patterned Growth of Carbon Nanotubes without Surface Carbon" in Appl. Phys. Lett. (2001), 79,10, 1534-1536, and by Kim et al. in "The Growth of Freestanding Single Carbon Nanotube Arrays", Nanotechnology, (2003), 14, 1269-1271. Likewise, the synthesis of CNTs growing out of nanoholes was demonstrated combining conventional lithography with ion milling for catalyst patterning and Chemical Vapour Deposition (CVD) for the growth as described by Duesberg et al. in "Growth of isolated Carbon Nanotubes with Lithographically Defined Diameter and Location", Nano Letters, (2003), 3, 2, 257-259.

Another method reported that evaporation of a catalyst through a shadow mask succeeded in controlling the synthesis of both MWCNTs and Single Wall Carbon Nanotubes (SWCNTs). By further varying these processes the synthesis of SWCNTs on patterned full wafers was demonstrated as described by Franklin, et al. in "Patterned Growth of Single-walled Carbon Nanotubes on full 4-inch wafers", Appl. Phys. Lett. (2001), 79, 27, 4571-4573 and by Kong, et al. in "Synthesis of Individual Single-walled Carbon Nanotubes on Patterned Silicon Wafers", Nature, (1998), 395, 878-881.

Alternatively, isolation of nanoparticles and CNT growth in fixed positions have been demonstrated using non-conventional techniques. Polystyrene nanosphere lithography was used to create large periodic arrays of Ni nanoparticles (see Huang et al. in "Growth of Large Periodic Arrays of Carbon Nanotubes", Appl. Phys. Lett. (2003), 82, 3, 460-462). The patterned catalysts produced CNTs with different diameters and site density. By choosing anodic aluminium oxide (AAO) as a template, Co nanoparticles were placed within the nanopores of the AAO template. As-grown CNTs from such nanoparticles were confined within the nanopores. In transferring localized growth for device fabrication, several approaches have been demonstrated. Two of them could improve the integration density. First, the growth of single standing CNTs in gate holes for field emission display (FED) applications was demonstrated. More specifically, a silicon nitride SiNₓ capping layer was deposited on a Ni catalyst. Wet etching was then applied for making holes in the SiNₓ layer, which were first defined by conventional lithography, without reaching the Ni underneath. Further annealing allows diffusing of Ni atoms into the SiNₓ and form Ni grains on the SiNₓ surface in the holes. Exposing the Ni grains to growth conditions, CNTs only grew inside the gate holes. Second, electromechanical switching devices have been fabricated employing vertically grown CNTs from pre-patterned catalyst dots on patterned device electrodes. The device consists of three MWCNTs grown from predefined positions on three Nb electrodes. The electrodes were patterned by e-beam lithography, sputtering and lift off. Likewise, Ni catalyst dots were formed on the electrodes and CNT grew afterwards.

Despite the improvements achieved up till now, exact placement of catalytic nanoparticles remains critical and growth of CNTs in uniform arrays has not been achieved up till now in such a way that it is scalable and fully compatible with existing semiconductor processing in an economical attractive and realistic way.

### Summary of the invention

It is an object of the present invention to provide a good method for forming catalyst nanoparticles on a substrate. It is a further object of the present invention to provide a good method for forming elongate nanostructures, such as e.g. CNTs, on a substrate.

The above objectives are accomplished by methods and devices according to the present invention.

The methods according to embodiments of the invention are scalable and fully compatible with existing semiconductor processing.

Furthermore, the methods according to embodiments of the invention allow forming catalyst nanoparticles and elongate nanostructures on predetermined locations on a substrate in an accurate way.

Moreover, methods according to embodiments of the invention allow growing elongate nanostructures such as e.g. CNTs with control over the diameter and length of the CNTs.

The methods according to embodiments of the invention provide a method for creating patterned and selectively deposited nanoparticles with narrow size distribution in predetermined locations of a substrate. Said narrow size distribution can be expressed as a size distribution having a variation limited to 5-10% or wherein the variation in diameter sizes of the nanoparticles is within 5-10%. These patterned nanoparticles can be used for catalysing nucleation and growth of elongate nanostructures selectively in the locations where catalyst particles are present.

In a first aspect of the invention, a method is provided for forming catalyst nanoparticles on a substrate. The method comprises:
- forming recesses in the substrate at predetermined locations, the recesses having a bottom,
- providing nanoparticles onto the substrate, and
- selectively removing nanoparticles provided at locations different from the bottom of the recesses.

An advantage of the method for forming catalyst nanoparticles on a substrate according to embodiments of the invention is that it can be used with any size of substrate. Furthermore, it is fully compatible with existing semiconductor processing, e.g. for manufacturing nano-devices. Furthermore, the method for forming catalyst nanoparticles on a substrate provides catalyst nanoparticles on a substrate with narrow size distribution.

Furthermore, the method allows providing catalyst nanoparticles at predetermined locations on the substrate.

According to embodiments of the invention, providing nanoparticles onto the substrate may be performed by:
- providing at least one layer of catalyst material onto the substrate such that the catalyst material at least covers the bottom of the recesses, and
- breaking up the at least one layer of catalyst material into nanoparticles.

Breaking up the at least one layer of catalyst material into nanoparticles may be performed by a thermal and/or plasma assisted method. Preferably, breaking up the at least one layer of catalyst material into nanoparticles may be performed by heating the substrate.

According to embodiments of the invention, the layer of catalyst material may be a layer comprising at least one metal, or a layer comprising a metal alloy or a layer comprising a metal-silicide. Consequently, the nanoparticles formed by the method according to embodiments of the invention may be pure metal nanoparticles comprising at least one metal, may be metal alloy nanoparticles or may be metal-silicide nanoparticles.

According to other embodiments, providing nanoparticles onto the substrate may be performed by:
- depositing the nanoparticles onto the substrate from a solution comprising the nanoparticles and a solvent, and
- after deposition of the nanoparticles, removing the solvent.

Removing the solvent may be performed by evaporation.

In the method according to embodiments of the invention, first a standard array of recesses may be formed on a substrate. The standard array of recesses may then be used as a template for placement of catalyst nanoparticles. With standard array is meant that the array is formed using standard semiconductor processes of lithography and dry etching. By using these standard processes, recesses may be formed having, for example, a diameter of between 50 nm and 500 nm, for example a diameter of 80 nm or 100 nm or 150 nm or 200 nm or 250 nm or 300 nm, with pitches of, for example, 1, 2 or 8 times the diameter. The aspect ratios of the recesses may, for example, be 1:6, 1:4, 1:3, 1:2.5 or 1:2.

The diameter of the nanoparticles to be formed depends on the application. The nanoparticles formed by the method according to embodiments of the invention may have a diameter of smaller than 100 nm. According to specific embodiments, where single wall CNTs have to be formed using the catalyst nanoparticles, the nanoparticles may have a diameter smaller than 3 nm. According to other specific embodiments, where multiwall CNTs have to be formed using the catalyst nanoparticles, the nanoparticles may have a diameter in the range of between 5 and 10 nm.

Selectively removing nanoparticles formed at locations different from the bottom of the recesses may be performed by:
- depositing a sacrificial material onto the substrate such that the sacrificial material at least covers the nanoparticles provided at the bottom of the recess,
- removing the nanoparticles provided at locations different from the bottom of the recesses, and
- removing the sacrificial material.

By using a sacrificial layer for covering at least the nanoparticles provided at the bottom of the recesses, the nanoparticles at locations different from the bottom of the recesses can be removed without affecting the nanoparticles formed at the bottom of the recesses. Furthermore, the nanoparticles provided at the bottom of the recesses are protected by the sacrificial layer from influences of subsequent processes, more particularly of a chemical mechanical polishing process for removing the nanoparticles provided at locations different from the bottom of the recesses, hereby avoiding contamination of the nanoparticles which will be used for growing elongate nanostructures.

Removing the sacrificial material may be performed by any suitable means known to a person skilled in the art, for example by a wet cleaning process.

According to embodiments of the invention, forming recesses in the substrate at predetermined locations may be performed by etching the recesses in the substrate at the predetermined locations. The method may furthermore comprise, before etching, lithographically defining the predetermined locations on the substrate. By using this method, locations where recesses have to be formed can very accurately be determined.

According to embodiments of the invention, the substrate may comprise a base substrate. Forming recesses in the substrate at predetermined locations may be performed by forming recesses in the base substrate. This may be advantageous to be used in the manufacturing of e.g. semiconductor devices where a contact is required between the elongate nanostructures which may be grown on the substrate using the nanoparticles as a catalyst and the base substrate.

According to other embodiments of the invention, the substrate may comprise a base substrate and a dielectric layer. Forming recesses in the substrate at predetermined locations may be performed by forming recesses in the dielectric layer of the substrate. This may be advantageous to be used in the manufacturing of e.g. semiconductor devices where there may not be a contact between elongate nanostructures which may be grown on the substrate using the nanoparticles as a catalyst and the base substrate.

According to embodiments of the invention, the method may furthermore comprise removing impurities from edges of the recesses. These impurities may be residues from the process used to remove nanoparticles formed at locations different from the bottom of the recesses. Alternatively or on top thereof, these residues may be residues from the sacrificial layer used to protect the nanoparticles formed at the bottom of the recesses from the process used to remove nanoparticles formed at locations different from the bottom of the recesses.

According to specific embodiments, removing impurities from edges of the recesses may be performed by etching, e.g. by immersing the substrate in a 1:4 H₂SO₄:H₂O₂ solution for 5 minutes, also referred to as piranha etch.

The method according to embodiments of the first aspect of the invention may be used in a growth process of elongate nanostructures on a substrate.

In a second aspect, the present invention provides a method for forming elongate nanostructures on a substrate. The method comprising:
- forming recesses in the substrate at predetermined locations, the recesses having a bottom,
- providing nanoparticles onto the substrate,
- selectively removing nanoparticles provided at locations different from the bottom of the recesses, and
- growing elongate nanostructures in the recesses using the nanoparticles provided at the bottom of the recesses as a catalyst.

An advantage of the method for forming elongate nanostructures on a substrate according to embodiments of the invention is that it can be used with any size of substrate. Furthermore, it is fully compatible with existing semiconductor processing, e.g. for manufacturing nano-devices.

A further advantage of the method for forming elongate nanostructures on a substrate according to embodiments of the invention is that they allow forming elongate nanostructures with a controlled and predetermined diameter and length.

Furthermore, with the method for forming elongate nanostructures on a substrate according to embodiments of the invention it is possible to provide elongate nanostructures at predetermined locations on a substrate.

According to embodiments of the invention, providing nanoparticles onto the substrate may be performed by:
- providing at least one layer of catalyst material onto the substrate such that the catalyst material at least covers the bottom of the recesses, and
- breaking up the at least one layer of catalyst material into nanoparticles.

Breaking up the at least one layer of catalyst material into nanoparticles may be performed by a thermal and/or plasma assisted method. Preferably, breaking up the at least one layer of catalyst material into nanoparticles may be performed by heating the substrate.

According to other embodiments, providing nanoparticles onto the substrate may be performed by:
- depositing the nanoparticles onto the substrate from a solution comprising the nanoparticles and a solvent, and
- after deposition of the nanoparticles, removing the solvent.

Removing the solvent may be performed by evaporation.

According to embodiments of the invention, the nanoparticles may be pure metal nanoparticles, may be metal alloy nanoparticles or may be metal-silicide nanoparticles.

The elongate nanostructures may preferably be carbon nanotubes (CNTs) or nanowires (NWs).

In the method according to embodiments of the invention, first a standard array of recesses may be formed on a substrate. The standard array of recesses may then be used as a template for placement of catalyst nanoparticles. With standard array is meant that the array is formed using standard semiconductor processes of lithography and dry etching. By using these standard processes, recesses may be formed having, for example, a diameter of between 50 nm and 500 nm, for example a diameter of 80 nm or 100 nm or 150 nm or 200 nm or 250 nm or 300 nm, with pitches of, for example, 1, 2 or 8 times the diameter. The aspect ratios of the recesses may, for example, be 1:6, 1:4, 1:3, 1:2.5 or 1:2.

Growth of elongate nanostructures with control over diameter and length may then be performed inside the recesses using the nanoparticles as catalyst.

Growing elongate nanostructures in the recesses may be performed by a chemical vapour deposition process. This may, for example, be done by:
- providing a carbon source and an assistant gas, and
- growing elongate nanostructures by heating the substrate.

Growing elongate nanostructures may preferably be performed by heating the substrate to a temperature between 600°C and 800°C.

Selectively removing nanoparticles formed at locations different from the bottom of the recesses may be performed by:
- depositing a sacrificial material onto the substrate such that the sacrificial material at least covers the nanoparticles provided at the bottom of the recess,
- removing the nanoparticles provided at locations different from the bottom of the recesses, and
- removing the sacrificial material.

By using a sacrificial layer for covering at least the nanoparticles provided at the bottom of the recesses, the nanoparticles at locations different from the bottom of the recesses can be removed without affecting the nanoparticles formed at the bottom of the recesses. Furthermore, the nanoparticles provided at the bottom of the recesses are protected by the sacrificial layer from influences of subsequent processes, more particularly of a chemical mechanical polishing process which may be used for removing the nanoparticles provided at locations different from the bottom of the recesses, hereby avoiding contamination of the nanoparticles provided at the bottom of the recesses.

According to embodiments of the invention, forming recesses in the substrate at predetermined locations may be performed by:
- lithographically defining the predetermined locations on the substrate, and
- etching the recesses in the substrate at the predetermined locations.

By using this method, locations where recesses have to be formed can very accurately be determined.

According to embodiments of the invention, the substrate may comprise a base substrate. Forming recesses in the substrate at predetermined locations may be performed by forming recesses in the base substrate. This may be advantageous when used in the manufacturing of e.g. semiconductor devices where a contact is required between the elongate nanostructures which may be grown on the substrate using the nanoparticles as a catalyst and the base substrate.

According to other embodiments of the invention, the substrate may comprise a base substrate and a dielectric layer. Forming recesses in the substrate at predetermined locations may be performed by forming recesses in the dielectric layer of the substrate. This may be advantageous when used in the manufacturing of e.g. semiconductor devices where there may not be a contact between elongate nanostructures which may be grown on the substrate using the nanoparticles as a catalyst and the base substrate.

According to embodiments of the invention, growing elongate nanostructures may be performed by base growth.

According to embodiments of the invention, growing elongate nanostructures may be performed by tip growth.

The method for forming elongate nanostructures on a substrate according to embodiments of the second aspect of the invention may be used in semiconductor processing.
The present invention also provides a substrate provided with catalyst nanoparticles wherein the catalyst nanoparticles are selectively provided in recesses of the substrate and a substrate provided with elongate nanostructures wherein the elongate nanostuctures are selectively provided in recesses of the substrate. The elongate nanostructures can be formed using a substrate with catalyst nanoparticles that have been selectively provided in the recesses.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

All drawings are intended to illustrate some aspects and embodiments of the present invention. Not all alternatives and options are shown and therefore the invention is not limited to the content of the attached drawings. Like numerals are used to reference like parts in the different figures. The figures may show preferred embodiments.

Figures 1A to 1F illustrate a method for CNT growth in recesses in a substrate according to embodiments of the present invention.
Figures 2A to 2D show top view SEM images of different processing steps during selective deposition of nanoparticles according to embodiments of the invention.

Figure 3A and 3B illustrate histograms for respectively the number and the diameter distribution of nanoparticles formed after annealing of a 2 nm thick Ni catalyst layer at 700°C for 1 min. for recesses with a diameter of 100 nm.
Figure 4A and 4B illustrate histograms for respectively the number and diameter distribution of CNTs grown from particles formed after annealing of a 2 nm thick Ni catalyst layer at 700°C for 1 min. for recesses with a diameter of 100 nm and grown at 700°C at a constant ethylene flow of 200 ml/min. for 1 min.

Figures 5A to 5C illustrate top view SEM images of arrays of CNTs grown according to specific embodiments of the invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Moreover, the terms top, bottom and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

The present invention relates to a method for providing catalyst nanoparticles on a substrate.

The method comprises in a first step forming at predetermined locations in the substrate holes or recesses having a bottom. The recesses, also called holes or openings, are formed from a substrate surface into the substrate, and the bottom is located at that side of the recess furthest away from the substrate surface where the recess is formed. The terms recess, hole or opening hereinafter are intended to mean the same thing.

Next, nanoparticles are provided onto the substrate. According to preferred embodiments of the invention, providing nanoparticles onto the substrate may be performed by providing at least one layer of catalyst material onto the substrate such that the catalyst material at least covers the bottom of the recesses. Then, the at least one layer of catalyst material is broken up into nanoparticles. This may be done by using thermal and/or plasma assisted methods. For example breaking up the layer of catalyst material may be done by annealing the substrate (see further). According to other embodiments, providing nanoparticles onto the substrate may be performed by depositing the nanoparticles from a solution comprising the nanoparticles and a solvent. Depositing the nanoparticles onto the substrate may, for example, be done by spinning on the solution. After deposition of the nanoparticles onto the substrate, the solvent may be removed from the solution by e.g. evaporation during a thermal drying step such that only the nanoparticles remain on the substrate.

In a last step, nanoparticles provided or formed at locations different from the bottom of the recesses, e.g. at the substrate surface in between two recesses, are selectively removed.

The present invention thus provides a method to create and isolate nanoparticles with narrow size distribution in predefined locations in a substrate. The narrow size distribution can be expressed as a size distribution having a variation in size or diameter between 5 and 10% or wherein the variation in diameter or size of the nanoparticles is within 5 and 10%, preferably between 5 and 8% (see further). The material of the nano-particles depends on the catalyst material used. The nanoparticles may preferably be metal-containing nanoparticles. According to preferred embodiments, the selectively deposited nanoparticles may be pure metal nanoparticles. According to other and also preferred embodiments, the selectively deposited nanoparticles may be metal-silicide containing nanoparticles. According to still other and also preferred embodiments, the selectively deposited nanoparticles may be metal alloys.

An advantage of the method for forming catalyst nanoparticles on a substrate according to embodiments of the invention is that it can be used with any size of substrate. Furthermore, it is fully compatible with existing semiconductor processing, e.g. for manufacturing nano-devices.

The catalyst nanoparticles formed by the method for providing catalyst nanoparticles on a substrate according to embodiments of the invention may advantageously be used as a catalyst for growing elongate nanostructures. These nanoparticles deposited at predetermined locations on the substrate can catalyse the nucleation and growth of elongate nanostructures, e.g. carbon nanotubes (CNTs) or nanowires (NWs). Hence, elongate nanostructures, e.g. CNTs or NWs, can be grown at predetermined locations on a substrate. Selectively deposited CNTs or NWs with control over diameter and length as well as location can be achieved (through growth) using said nanoparticles as catalyst. To achieve such CNT (or NW) growth, standard arrays of recesses may be used as templates for catalyst placement and CNT (NW) are grown inside the holes using e.g. Chemical Vapor Deposition (CVD) techniques. With standard array of recesses is meant that the array of recesses is formed using standard semiconductor processes of lithography and dry etching. By using these standard processes, recesses may be formed having, for example, a diameter of between 50 nm and 500 nm, for example a diameter of 80 nm or 100 nm or 150 nm or 200 nm or 250 nm or 300 nm, with pitches of, for example, 1, 2 or 8 times the diameter. The aspect ratios of the recesses may, for example, be 1:6, 1:4, 1:3, 1:2.5 or 1:2.

The present invention thus also provides a method for forming elongate nanostructures on a substrate. The method comprises in a first step forming recesses in the substrate at predetermined locations, the recesses having a bottom. The bottom is defined as that wall of the recess furthest away from the substrate surface in which the recess is made. Next at least one layer of catalyst material is provided onto the substrate such that the catalyst material at least covers the bottom of the recesses. In a next step, the at least one layer of catalyst material is broken up into nanoparticles, e.g. by annealing the substrate. Thereafter, nanoparticles formed at locations different from the bottom of the recesses are selectively removed. In a last step, elongate nanostructures, e.g. CNTs or NWs, are grown in the recesses using the nanoparticles as a catalyst.

The method for forming elongate nanostructures on a substrate according to embodiments of the invention can be used with any size of substrate and is fully compatible with semiconductor processing technology.

Hereinafter, the invention will be described by means of a detailed description of several embodiments. It is clear that other embodiments can be configured according to the knowledge of persons skilled in the art without departing from the true spirit or technical teaching of the invention, the invention being limited only by the terms of the appended claims.

According to the invention, with the term elongate nanostructures is meant any two-dimensionally confined pieces of solid material in the form of wires (nanowires), tubes (nanotubes), rods (nanorods) and similar elongated substantially cylindrical or polygonal nanostructures having a longitudinal axis. A cross-dimension of the elongate nanostructures preferably lies in the region of 1 to 500 nanometers. According to the invention, organic elongate nanostructures, such as e.g. carbon nanotubes (CNTs), or inorganic elongate nanostructures, such as e.g. semiconducting nanowires (e.g. silicon nanowires) may be used. Hereinafter, the invention will be described by means of CNTs. This is not intended to limit the invention in any way. The present invention also applies to other elongate nanostructures as described above.

Furthermore, the terms "base growth" or "bottom up growth" of CNTs as used in this application refer to CNT growth having the catalyst nanoparticle attached to the substrate. The terms "tip growth" or "top down growth" of CNTs as used in this application refer to CNT growth having the CNTs attached to the surface and the nanoparticle being on top of the CNTs.

Furthermore, the terms "pure metal" nanoparticles refers to nanoparticles made of pure metal or nanoparticles formed by annealing a pure metal film. The term "metal-silicide" nanoparticles refers to nanoparticles made of metal-silicides such as Ni-silicide, Co-silicide, Fe-silicide, Ti-silicide,.... The term "metal-containing" nanoparticles refer to both metal nanoparticles and metal-silicide nanoparticles. The term "alloy" as used in this specification refers to a mixture containing two or more metallic elements or metallic and nonmetallic elements which are fused together during an anneal (heating) step and thus dissolving into each other to result in nanoparticles containing two or more metallic elements or metallic and nonmetallic elements.

The term "active catalyst nanoparticles" refers to nanoparticles which are suitable to be used as a catalyst for CNT (or NW) growth. In other words, "active" is to be understood as being capable of growing/synthesizing/creating a carbon nanotube using the formed nanoparticles. The growth/synthesis/ creation of a carbon nanotube is a multi-step process of first receiving a carbon source, followed by cracking the carbon and subsequently growing the carbon nanotube.

The term "aspect ratio" refers to the ratio of the height dimension to the width dimension of particular recesses. For example, a recess which typically extends in a tubular form into a layer has a height and a diameter, and the aspect ratio would be the height of the tubular recess divided by the diameter.

In a first aspect of the invention, a method is provided for providing catalyst nanoparticles on a substrate S. In embodiments of the present invention, the term "substrate" may include any underlying material or materials that may be used, or upon which a device, a circuit or an epitaxial layer may be formed. In preferred embodiments, this "substrate" may include a semiconductor substrate such as e.g. a doped silicon, a gallium arsenide (GaAs), a gallium arsenide phosphide (GaAsP), an indium phosphide (InP), a germanium (Ge), or a silicon germanium (SiGe) substrate. According to alternative embodiments, the "substrate" may include for example, an insulating layer such as a SiO₂ or an Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer. Preferably, the substrate S may be a silicon substrate.

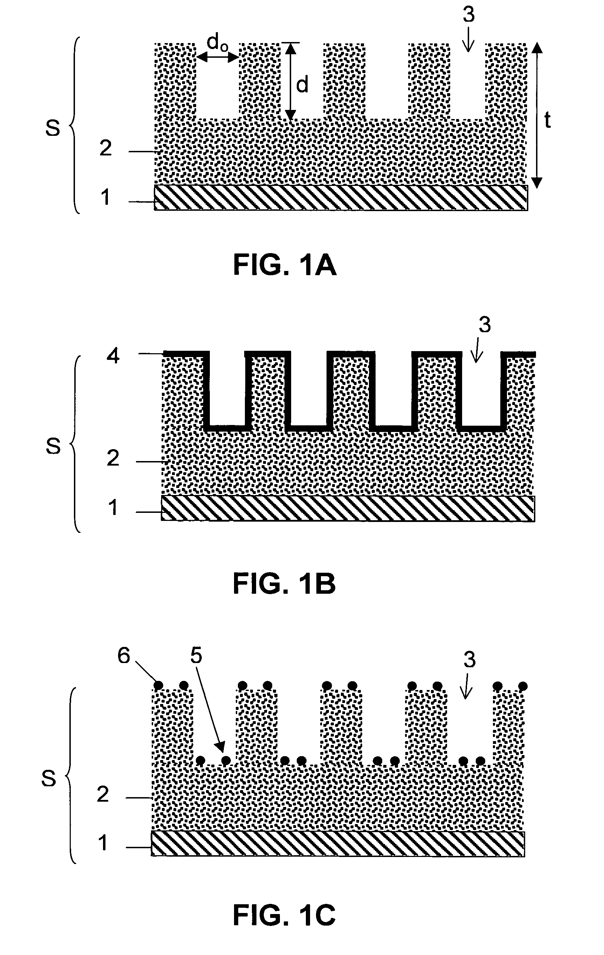

The method according to embodiments of the invention is schematically illustrated in Figures 1A to 1F. In a first step, the method comprises forming recesses 3 in the substrate S at predetermined locations. Most preferably, standard arrays having rows and columns of recesses 3 may be formed. As already described above, with standard arrays of recesses is meant that the arrays of recesses are formed using standard semiconductor processes of lithography and dry etching. By using these standard processes, recesses may be formed having, for example, a diameter of between 50 nm and 500 nm, for example a diameter of 80 nm or 100 nm or 150 nm or 200 nm or 250 nm or 300 nm, with pitches of, for example, 1, 2 or 8 times the diameter. The aspect ratios of the recesses may, for example, be 1:6, 1:4, 1:3, 1:2.5 or 1:2. The standard arrays of recesses 3 can be formed directly in the substrate S, but more preferred the standard arrays of recesses 3 may be formed in a dielectric layer 2 deposited onto a base substrate 1, the dielectric layer 2 and the base substrate 1 together forming the substrate S. The dielectric layer 2 can be a SiO₂ layer which may, for example, be formed by thermally annealing a Si substrate or alternatively by depositing a SiO₂ layer e.g. by deposition techniques such as Chemically Vapor Deposition (CVD). The dielectric layer 2 may be a low-k dielectric layer such as CVD deposited SiCO(H) material, zeolites, NCS or (suitable) organic low-k materials. The thickness t of the dielectric layer 2 is dependent on the application and may, for example, be in the range of between 100 nm and 1000 nm.

According to the embodiment illustrated in Figures 1A to 1F, the substrate S may comprise a base substrate 1, e.g. a semiconductor layer, with on top a dielectric layer 2 as described above. Preferably, the base substrate 1 may comprise silicon. Figure 1A illustrates the formation of recesses 3 in said substrate S. According to the embodiment illustrated, recesses 3 may be formed in the dielectric layer 2 present on the base substrate 1. The recesses 3 may lithographically be defined using standard lithographic processing followed by standard dry oxide etching such as e.g. reactive ion etching to form the recesses 3 in the substrate S. Standard lithographic processing may at least comprise depositing at least one photosensitive layer, for example a photoresist layer and optionally an antireflective coating, onto the dielectric layer 2 and developing the photosensitive layers to create a photolithographic pattern. The photolithographic pattern may then be used as a mask in e.g. reactive ion etching to form recesses 3 in the dielectric layer 2.

The diameters do of the recesses 3 may depend on the application. The diameters do of the recesses 3 may be between 50 nm and 500 nm and may, for example, be 80 nm, 100 nm or 150 nm or 200 nm or 250 nm or 300 nm. The depth d of the recesses 3 may depend on the application and on the thickness t of the dielectric layer 2 if one is present. For example, the depth d can be smaller than the thickness t of the dielectric layer 2 in case the recesses 3 are created into the dielectric layer 2 and contact between catalyst particles to be formed (see further) and the base substrate 1 underneath the dielectric layer 2 needs to be avoided. Alternatively, the depth d can be higher than the thickness t of the dielectric layer in case the recesses 3 are created into the dielectric layer 2 and contact to the base substrate 1 underneath is required, desired or allowed. The depth d of the recesses 3 may, for example, be in the range of between 500 nm and 1000 nm but is not limited hereto.

According to still other embodiments, the substrate S may only comprise a base substrate 1 without a dielectric layer 2 on top of this base substrate 1. In this case, recesses 3 may be provided in the base substrate 1 of the substrate S.

The recesses 3 may be provided in dense, semi-dense or isolated arrays. Dense arrays typically may have a pitch of 1, semi-dense arrays may typically have a pitch of 1:2 and isolated arrays may typically have a pitch of 1:8. With pitch is meant the distance between neighbouring recesses 3. The aspect ratio of the recesses 3 may, for example, be 1:6, 1:4, 1:3, 1:2.5 or 1:2.

After forming the recesses 3, nanoparticles are provided onto the substrate. According to the present example, providing nanoparticles may be provided by depositing at least one layer 4 of catalyst material onto the substrate S. Figure 1B illustrates the deposition of a layer 4 of catalyst material onto the dielectric layer 2 of the substrate S. It can be seen from the figure that, according to the present embodiment, the layer 4 of catalyst material is provided on a top surface of the dielectric layer 2 and on a bottom and side walls of the recesses 3. It has to be noted that, contrary to the example given in Figure 1B, the layer 4 of catalyst material may also only be provided at the bottom of the recesses 3. It is to be noted that, in the latter case, also catalyst material will end up on the surface of the substrate S.

The at least one layer 4 of catalyst material may preferably be a metal-containing layer. At least one of the at least one layer 4 of catalyst material may be a metal-containing layer 4. Preferably, the thickness of the at least one layer 4 of catalyst material may be lower than 20 nm and may more preferably be between 1 nm and 10 nm. For example, the layer 4 of catalyst material may have a thickness of 2 nm, 5 nm, 8 nm, 9 nm or 10 nm. According to other embodiments, the thickness of the layer 4 of catalyst material may be lower than 1 nm, which may lead to small nanoparticles with a diameter in the range of between 0.2 nm and 0.5 nm. Depending on the thickness of the layer 4 of catalyst material, the layer 4 of catalyst material can be discontinuous on the top surface of the dielectric layer 2. Depending on the thickness of the layer 4, it can have different thicknesses inside the recesses 3. Most of the layer 4 of catalyst material inside the recesses 3 is located at the bottom of the recesses 3, especially when the layer 4 of catalyst material has a thickness lower than 8 nm.

The layer 4 of catalyst material may comprise a material that, when heated up, leads to formation of active catalyst nanoparticles. The layer 4 of catalyst material may preferably comprise a metal and may according to most preferred embodiments comprise pure metal such as e.g. Co, Ti, Pt, W, Ni or Fe. Preferably, the pure metal layer may be deposited using sputter techniques such as Physical Vapor Deposition (PVD) or deposition techniques such as Atomic Layer Deposition (ALD) or Chemical Vapor Deposition (CVD).

According to other embodiments, the layer 4 of catalyst material may comprise a combination of a plurality of layers, for example, two layers, preferably two layers formed of metal such as e.g. Co, Ti, Pt, W, Ni or Fe. Again, preferably, the two layers of metal may be deposited using sputter techniques such as Physical Vapor Deposition (PVD) or deposition techniques such as Atomic Layer Deposition (ALD) or Chemical Vapor Deposition (CVD). It has to be noticed that a combination of any number of layers is also disclosed by the present invention. Furthermore, the combination of two or more layers can also be a combination of at least one pure metal layer and at least one non-pure metal layer and/or at least one non-metal layer.

According to still other embodiments, the layer 4 of catalyst material may comprise a metal alloy.

It is to be noted that care has to be taken when the substrate S comprises silicon and the layer 4 of catalyst material is a metal or metal alloy containing layer. In this case, when breaking up the layer 4 of catalyst material by means of a thermally assisted method, during heating substrate interaction can occur between the catalyst material and the substrate S to form a silicide. In order to avoid that, preferably an intermediate barrier layer may be provided in between the substrate S and the layer 4 of catalyst material. The barrier layer may, for example, be Si₃N₄, TiN, TaN, HfN, SiO₂, Si₃N₄, ... and may, for example, have a thickness of between 50 nm and 100 nm.

According to yet further embodiments, the layer 4 of catalyst material may comprise a metal-silicide. In this case, first a layer of silicon and a layer of metal may be deposited on the substrate S. Preferably a layer of silicon may be deposited onto the substrate S before the metal layer is deposited. Most preferred, the silicon layer may be deposited using CVD. The metal layer for forming the metal-silicide may preferably be Co, Ni, Ti, W, Pt or Fe. Preferably the metal layer may be deposited using PVD, ALD or CVD. In case the substrate S is a silicon substrate (e.g. a Si wafer), no dielectric layer 2 is present on the base substrate 1 and the layer 4 of catalyst material comprises metal-silicide, a barrier layer may be deposited onto the base substrate 1 before depositing the silicon layer in order to avoid migration of metal-silicide nanoparticles into the base substrate 1. Similarly as described above, the barrier layer may, for example, be Si₃N₄, TiN, TaN, HfN, SiO₂, Si₃N₄, ... and may, for example, have a thickness of between 50 nm and 100 nm.

Figure 1C illustrates transformation of the at least one layer 4 of catalyst material into nanoparticles 5, 6 by thermal and/or plasma assisted methods, e.g. by performing an annealing or heating step on the substrate S. Annealing the substrate S may be performed by, for example, a Rapid Thermal Anneal (RTA) at a temperature in the range of between 500°C and 900°C, preferably between 600°C and 800°C. The temperature at which annealing is performed may depend on the thickness of the layer 4 of catalyst material from which the nanoparticles 5, 6 have to be formed. Preferably, annealing the substrate S may be performed for a time period of at least one minute up to a few minutes. Preferably, the annealing may be performed under an N₂ atmosphere. The annealing may preferably be performed under vacuum circumstances without breaking the vacuum during annealing.

The stress achieved in the layer 4 of catalyst material during the annealing process gives rise to the formation of two-dimensional islands or nanoparticles 5, 6 in horizontal areas, as is illustrated in Figure 1C. The thickness of the layer 4 of catalyst material as well as the temperature and time duration of the annealing step may have influence in controlling the size and more particularly the diameter of the nanoparticles 5, 6. At same annealing conditions, thinner layers 4 may be transformed into smaller nanoparticles 5 with an increasing number density. The optimal temperature and time to create nanoparticles 5 may depend on the type of catalyst material used and the thickness of the layer 4 of the catalyst material. The required temperature at which annealing is performed depends on the thickness of the layer 4 of catalyst material and on the catalyst material used. In contrast, variation in the density of the arrays, i.e. the distance between neighbouring recesses 3, is found to have no significant impact on the formation of the nanoparticles 5, 6.

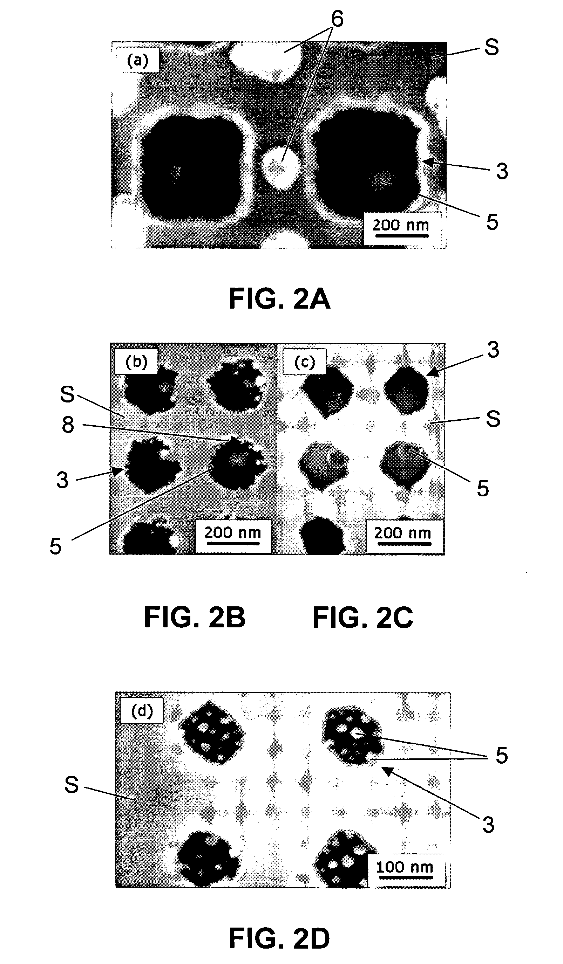

Figure 2A shows a top view Scanning Electron Microscopy (SEM) picture of nanoparticles 5 formed at the bottom of the recesses 3 and nanoparticles 6 formed at the substrate surface, after an annealing step at 700°C for 1 minute in case where the catalyst material comprises Nickel. According to this example, the layer 4 of catalyst material had a thickness of 2 mm. From this picture it can be seen that nanoparticles 6 are also formed at locations different from the bottom of the recesses 3, i.e. at the substrate surface. In the further description these nanoparticles 6 will be referred to as exterior nanoparticles 6.

It is to be noted that, according to other embodiments of the invention, nanoparticles 5, 6 may be provided onto the substrate S by depositing the nanoparticles 5, 6 from a solution comprising the nanoparticles 5, 6 and a solvent. Deposition of the nanoparticles 5, 6 may preferably be done by spinning on of the solution to the substrate S. The nanoparticle 5, 6 may be formed by any suitable method known by a person skilled in the art, and may then be mixed with a solvent in order to be able to spin it on the substrate S. After deposition of the nanoparticles 5, 6 the solvent may be removed such that only the nanoparticles 5, 6 remain at the bottom of the recesses 3 and at the surface of the substrate S. Removing the solvent may, for example, be done by evaporating the solvent during a thermal drying step.

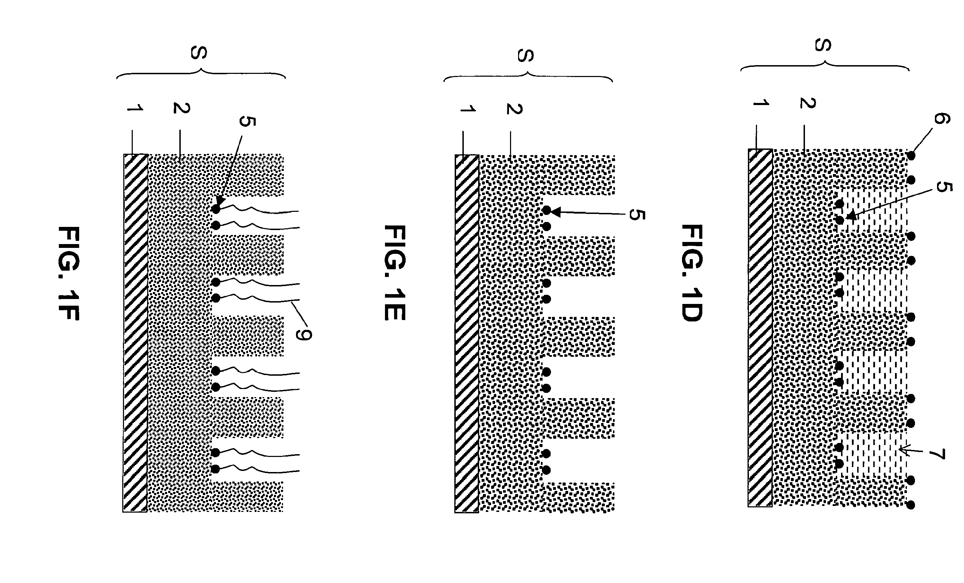

In a next step, the exterior nanoparticles 6 formed at locations different from the bottom of the recesses 3 may be selectively removed. Selectively removing of these exterior nanoparticles 6 may, for example, be performed as illustrated in Figure 1D. In a first step, the recesses 3 may at least partly be filled with a sacrificial material 7, hereby at least covering the nanoparticles 5 present at the bottom of the recesses 3. At least partly filling the recesses 3 with sacrificial material 7 may, fore example, be done by spin-on techniques. The sacrificial material 7 may be an organic material, preferably a commercially available organic material, and may preferably be an organic polymeric material such as e.g. photolithographic materials such as a resist. For example, at least partly filling the recesses 3 with sacrificial material 7 may be performed by depositing a sacrificial spin-on organic polymer 7 onto the substrate S such that at least the nanoparticles 5 in the recesses 3 are covered with the sacrificial spin-on organic polymer 7.

According to embodiments of the invention and as illustrated in Figure 1D, the recesses 3 may be completely filled with sacrificial material 7. This may preferably be performed by spinning on at a predetermined rotational speed, e.g. at 2000 rpm, for a predetermined time, e.g. one or two minutes. However, according to other embodiments, only part of the recesses 3 may be filled with sacrificial material 7. This may also preferably be done by spinning on, but in this case less sacrificial material is to be used because only partial filling of the recesses 3 is required. For example, the recesses 3 may be filled with sacrificial material 7 for one half or one third of the recesses 3, as long as the nanoparticles 5 formed on the bottom of the recesses 3 are covered with the sacrificial material 7. The step of at least partly filling the recesses 3 and thereby covering the nanoparticles 5 present at the bottom of the recesses 3 is mainly performed to protect the nanoparticles 5 at the bottom of the recesses 3 during further processing, more particularly during selective removal of the exterior nanoparticles 6 at locations different from the bottom of the recesses 3. Removing the exterior nanoparticles 6 may preferably be done by Chemical Mechanical Polishing (CMP). Furthermore, this step also protects the nanoparticles 5 formed at the bottom of the recesses 3 from external post-processing residues which could lead to unwanted contamination.

After the selective removal of the exterior nanoparticles 6, e.g. the CMP process, has been performed, the sacrificial material 7 may be removed. This may be done by a cleaning step which may be for example be a standard wet cleaning process suitable for removing the sacrificial material 7 without damaging the material of the substrate S. This cleaning step removes the sacrificial material 7 from the recesses 3, thereby releasing the nanoparticles 5 formed at the bottom of the recesses 3.

After the cleaning step for removing the sacrificial material 7, there may still be some sacrificial material 7 present in the recesses 3 and there may also be small deposits of impurities 8 (Fig. 2B) at edges of the recesses 3, which may, for example, result from the CMP process (e.g. slurry residues) (see Figure 2B which shows a top view SEM picture after CMP and removal of the sacrificial material 7). Therefore, optionally an additional cleaning step, such as e.g. a wet etch, may be performed to remove these impurities 8. The wet etch may, for example, comprise immersing the substrate S in a solution comprising H₂SO₄ : H₂O₂ in a volume ratio of e.g. 1 : 4 for, for example, five minutes at room temperature, also referred to as piranha etching. Figure 1E schematically illustrates the substrate S after the CMP process through which exterior nanoparticles have been removed, and a subsequent cleaning process as described above. Figure 2C shows a top view SEM picture of a substrate S after piranha etching at room temperature for five minutes. From this SEM picture it can be seen that the impurities 8 have been removed.

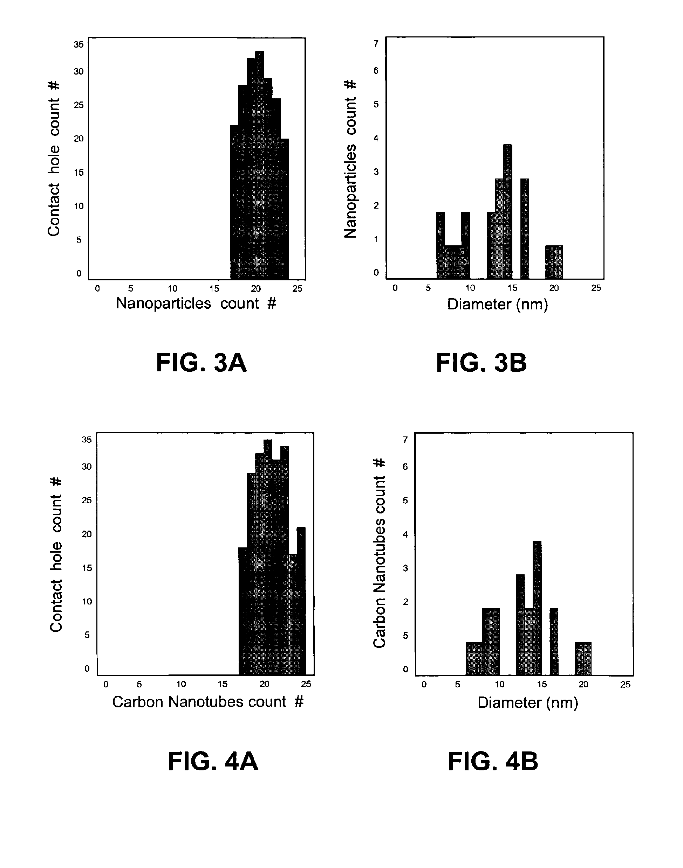

The number of nanoparticles 5 formed at the bottom of one recess 3 depends on the size of the nanoparticles 5 formed and on the diameter dₒ of the recess 3. The number of nanoparticles 5 formed in a recess 3 is illustrated in Figure 3A for a recess 3 having a diameter of 100 nm. Figure 3A shows a histogram for the number of nanoparticles 5 formed per recess 3 after annealing of a 2 nm thick Ni catalyst layer at 700°C for 1 min. for recesses 3 having a diameter of 100 nm. For an array with recesses having a diameter of 100 nm the average number of nanoparticles 5 within the recesses may be 20 +/- 0.51. A larger diameter of the recesses 3 will lead to a higher number of nanoparticles 5 formed in the recesses 3. Also the thickness of the layer 4 of catalyst material will have an impact on the number of nanoparticles 5 formed in the recesses 3 because the size of the nanoparticles 5 formed in the recess 3 depends on the thickness of the layer 4 of catalyst material that has been deposited onto the substrate S. Figure 3B illustrates a histogram of the size or diameter of nanoparticles 5 formed after annealing of a 2 nm thick Ni catalyst layer at 700°C for 1 min. in recesses 3 with a diameter of 100 nm. From Figure 3B it can be seen that the mean nanoparticle diameter formed after annealing of a 2 nm thick Ni catalyst layer as described above is 12.65 nm +/- 0.84. This is a deviation of 6.6%. From this it can be seen that, with the method according to embodiments of the invention, nanoparticles 5 can be formed with a narrow size distribution. According to the present invention, the narrow size distribution can thus be expressed as a size or diameter distribution having a variation of between 5 and 10%, preferably between 5 and 8% or wherein the variation in diameter sizes of the nanoparticles is within 5 to 10%, preferably within 5 and 8%.

The catalyst nanoparticles 5 formed at predetermined locations on a substrate S according to embodiments of the present invention may advantageously be used for growing CNTs, or in general elongate nanostructures, at the predetermined locations.

Therefore, the present invention also provides a method for forming elongate nanostructures on a substrate S. The method comprises providing catalyst nanoparticles at predetermined locations on a substrate S as described hereabove in embodiments of the present invention and subsequently growing elongate nanostructures in the recesses 3 using the nanoparticles 5 as a catalyst. Figure 1F illustrates growth of CNTs 9 using the nanoparticles 5 formed at the bottom of the recesses 3 as a catalyst. This may be done by exposing the nanoparticles to proper CNT synthesis conditions. The CNTs 9 may preferably be grown by Chemical Vapor Deposition (CVD) or Plasma Enhanced-CVD (PE-CVD). These methods use a carbon source such as e.g. CH₄ and C₂H₂, C₂H₄ and gases such as N₂ and/or H₂ as assistant gases. Most preferably, the method for growing the CNTs 9 may use C₂H₄ as a carbon source and gases such as N₂ and/or H₂ as assistant gases and may be performed at temperatures lower than 900°C, e.g. between 600°C and 800°C, as growth temperature. According to other embodiments, other carbon sources may be used, such as CH₄, and other growth temperatures may be required. For example, the growth temperature may be lower than 450°C to avoid damage to material of the substrate S on which the CNTs 9 are grown. For example, using other carbon sources than C₂H₄, growth temperatures lower than 500°C may also be suitable for growing CNTs 9. In general, the diameter of the formed CNTs 9 may be consistent with, i.e. may be substantially the same as, the diameter of the original catalyst nanoparticles 5. With decreasing nanoparticle sizes, the diameter of the CNTs 9 may become smaller, following a one to one relation. Massive growth of CNTs 9 occurs for pure metal nanoparticles 5 up to 800°C.

Figure 4A illustrates a histogram of the number of CNTs 9 grown from nanoparticles 5 formed after annealing of a 2 nm thick Ni catalyst layer at 700°C for 1 min. in recesses 3 having a diameter of 100 nm. The CNTs 9 are grown at 700°C and at a constant ethylene flow of 200 ml/min. for 1 min. For an array with recesses 3 having a diameter of 100 nm the average number of CNTs 9 formed within the recesses 3 may for example be 20 CNTs per recess 3.

Figure 4D shows a histogram for the diameter of the CNTs 9 grown from nanoparticles 5 formed after annealing of a 2 nm thick Ni catalyst layer at 700°C for 1 min. in recesses 3 having a diameter of 100 nm. The CNTs 9 are grown at 700°C and at a constant ethylene flow of 200 ml/min. for 1 min. From Figure 4B it can be seen that the mean CNT diameter is 12.5 nm.

CNTs 9 may, according to embodiments, be grown by base growth or bottom up growth or may, according to other embodiments, be grown by tip growth or top down growth, depending on the interaction of the catalyst material with the substrate S. For example, no interaction or a weak interaction of the catalyst material with the substrate S may lead to tip growth resulting in a CNT 9 with the nanoparticle 5 on top..

The properties of the resulting CNTs 9 may depend on the process parameters used during growth of the CNTs 9. For example, the resulting CNTs 9 may be straighter when the growth temperature is increased. Furthermore, at growth temperatures of 900°C only a few nanoparticles 5 can catalyze CNT growth. This effect is attributed to poisoning of the catalyst nanoparticles 5. Because of the high temperature, C₂H₄ decomposes faster than carbon diffuses into the catalyst nanoparticles 5. Hence, the catalyst particles 5 become covered with amorphous carbon and cannot catalyse CNT growth anymore.

The CNTs 9 can easily be released from the substrate S after growth if this would be required. This may, for example in case of low interaction between the CNT 9 and the substrate S, be done by rinsing with e.g. deionized water.

The method of the preferred embodiments for growing CNTs 9 based on the method according to embodiments of the invention can, for example, be used for manufacturing semiconductor devices. For example, tip growth or top down growth of CNTs 9, i.e. when the nanoparticles 5 are attached to the top of the CNTs 9, makes it easy to realize electrical contacts to the grown CNT 9.

Hereinafter, some examples illustrating the methods according to embodiments of the invention will be described.

### Example 1: Formation of metal nanoparticles

Pure metal nanoparticles 5, 6 resulting from an 8 nm and 2 nm thick layers of Ni and Co are evaluated.

A Ni layer 4 was deposited using Physical Vapor Deposition (PVD) and the layer 4 was annealed at a temperature of 700°C for 1 minute. The nanoparticle size distribution was determined by SEM characterization. Under the mentioned annealing conditions, the particle diameter of the nanoparticles 5, 6 originating from the 8 nm thick deposited Ni layer was 67 nm ± 6 nm. The particle diameter of the nanoparticles 5, 6 originating from the 2 nm thick deposited Ni layer was 17 nm ± 4 nm.

Pure metal nanoparticles 5, 6 resulting from an 8 nm and 2 nm thick Co layer show exactly the same behavior as observed for Ni layers with the same thickness.

It can thus be concluded that the diameter of the nanoparticles 5, 6 depends on the thickness of the layer 4 of catalyst material, in the example given the thickness of the metal, i.e. Ni or Co, layer 4. The thinner the layer 4 of catalyst material is, the smaller the diameter of the resulting nanoparticles 5, 6 will be.

### Example 2: Growth of CNTs using Co and Ni nanoparticles as a catalyst

In order to fully evaluate the catalytic activity of the Ni and Co (pure metal) nanoparticles 5 after the entire process of selectively obtaining nanoparticles 5 according to embodiments of the invention, the Ni and Co nanoparticles 5 were exposed to a wide range of synthesis conditions. A CVD chamber was used for performing CNT growth. The system may comprise a load-lock pre-chamber from which samples can be transferred, using a magnetic transfer rod, to a fixed bed reactor comprising an 80 mm diameter quartz tube, 120 cm in length and surrounded by a horizontal furnace. The pressure of the system can be varied from atmospheric pressure to 1 mbar, whereas the temperature can reach 1200°C. A carbon source, hydrogen and nitrogen gases are supplied directly to the fixed bed reactor at flow rates ranging from 100 to 5000 ml/min and a maximum pressure of 3 bar. All samples were preconditioned at the desired growth temperature. Each sample was placed in the centre of the reactor under a constant flow of carrier gases, in the example given a mix of N₂ and H₂, with flow rates of respectively 4000 ml/min and 2000 ml/min, for 2 minutes. Subsequently, ethylene was released into the furnace at different flow rates of 100ml/min, 200ml/min and 500ml/min. CNT growth was done under atmospheric pressure at several temperatures ranging from 600°C to 800°C and for different periods of time, i.e. for 1, 2, 5 and 10 minutes. After CNT growth, the samples were transferred back into the pre-chamber and allowed to cool down under N₂ ambient. The resulting CNTs were examined by Scanning Electron Microscopy (SEM) and High Resolution Transmission Electron Microscopy (HRTEM). Top-view analysis was carried out in a W-filament Philips X-30 and X-31 SEM. TEM images were recorded using a JEOL 2010F field emission gun (FEG) operated at an accelerating voltage of 200 keV.

Using the selectively obtained Co and Ni nanoparticles 5 as a catalyst, dense arrays of CNTs 9 were grown in the whole range of evaluated synthesis parameters. For both metals, massive growth was verified in all the cases. The influence of the flow rate of the carbon source, the temperature and the time period was investigated. From these parameters, it can be concluded that the time period during which annealing and growth was performed has a large effect on the length of the CNTs 9.

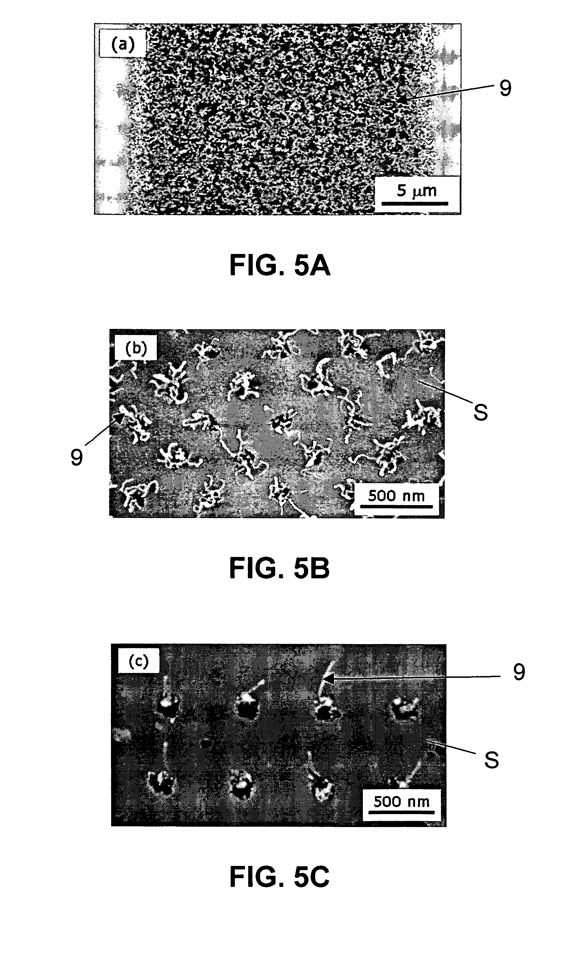

For example, after a time period of ten minutes of growth, long CNTs 9 with a length up to 15 µm may be obtained. The CNTs 9 obtained under these circumstances are entangled and may cover the whole array area on the surface of the substrate S, also outside the recesses 3, as is shown in Figure 5A. This indicates that massive growth of CNTs 9 can be obtained with the method according to embodiments of the invention. The CNTs 9 grow out of the recesses 3 and can then entangle with neighbouring CNTs 9 growing in the same recess 3 and even with CNTs 9 growing in neighbouring recesses 3. However, from experimental point of view, when obtaining such long entangled CNTs 9, it is difficult to examine their properties. Therefore, CNT growth was performed at shorter growth times, while keeping the rest of the growth parameters constant with respect to the above-described CNT growth process. By selecting an appropriate time period, the length of the CNTs 9 may be tailored hereby avoiding entanglement when CNTs 9 grow outside, i.e. above, the recess 3 as was the case in the above-described growth process which was illustrated in Figure 5A.

To address the impact of the time period on the growth and on the resulting CNTs 9, this parameter was systematically reduced. Down to even two minutes, no changes were observed. Still, the growth of entangled long CNTs 9 was observed. Reducing the time period of growth to one minute, it can be observed that CNTs 9 only protrude from each recess 3 and that CNTs 9 grown in neighbouring recesses 3 do not entangle. This is illustrated in Figure 5B which shows a top view SEM picture of an array of CNTs 9 grown at 700°C for 1 minute under a constant ethylene flow of 200 ml/min. This confirms the absence of catalytic nanoparticles 6 outside the recesses 3. It can be seen from Figure 5B that CNTs 9 are grown from the inside of the recesses 3 in bundles. This is due to the formation of several nanoparticles 5 per recess 3. In general, the 1-to-1 nanoparticle/nanotube ratio may easily be achieved. Uniformity in growth density, i.e. of the amount of CNTs 9 in one recess 3, in a same array of recesses 3 was observed, which indicates that the deposition of the layer 4 of catalyst material according to embodiments of the invention may be uniform.

Furthermore, catalytic activity of the selectively deposited nanoparticles 5 according to embodiments of the invention is comparable with that observed from blanket films, i.e. no loss in catalytic activity is observed by depositing it into the recesses 3 in the substrate S. The CNT diameter distribution is also observed to be uniform. Closer SEM inspection reveals that tube diameters vary accordingly with that of the nanoparticle from which it is grown, following a one to one relation, as is widely reported. This supports the fact that precise control of the CNT diameter is mainly limited by the size of the catalyst nanoparticles 5 from which the CNTs 9 are grown.

Hence, appropriate nanoparticle size, formed and isolated by the method according to embodiments of the invention, must be achieved to grow monodispersed CNT arrays. Except for the length of the CNTs 9, the time period of growth does not seem to modify other properties of the resulting CNTs 9.

Differences in morphology, however, are observed when changing either the growth temperature or the carbon source flow rate. As-grown CNTs 9 show twisted structures at 600°C. Increasing the growth temperature leads to straighter CNTs 9. This phenomenon has been attributed to the fact that higher temperatures produce fewer defects in the resulting CNTs 9 and better graphitization of CNT walls. In varying the carbon source flow rate, an optimal value was observed from which no amorphous-C is deposited. To some extent, for the same nanoparticle size, the flow can be increased accordingly with the temperature. Massive growth occurring by a tip growth mechanism is verified in the whole range of evaluated parameters. In tip growth, the catalytic nanoparticle remains at the top of each CNT. This phenomenon may take, for example, place in case the substrate S comprises a base substrate 1 and a SiO₂ layer 2 on top of the base substrate 1, since the nanoparticles 5 do not adhere to the SiO₂ layer 2 on which they are formed. As a consequence, as-grown CNTs 9 tend to easily lift off from the substrate S. This phenomenon is especially observed for long periods of growth times due to CNT entanglement. Overall, all features described above were observed in the centre as well as in edge areas of the substrate S. Moreover, Ni and Co nanoparticles 5 did not show any difference in terms of catalytic behavior.

### Example 3: Evaluation of growth parameters in CVD grown CNT

For a further evaluation of growth parameters as described in example 2, the time period of growth and the carbon source flow rate were reduced to respectively 30 seconds and 10 ml/min, while the growth temperature was increased to 900°C. An immediate effect on the growth of the CNTs 9 was observed. This is illustrated in Figure 5C. Single CNTs 9 were grown from only some of the recesses 3, not from all of the recesses 3. Due to the limited amount of carbon source and reduced growth time, CNT length was controlled. In addition, an effect on the morphology was clearly observed. All CNTs 9 were straight. On the other hand, not all the nanoparticles appeared to be active under these circumstances. This is probably due to a poisoning effect at high temperature, as already described above.

### Example 4: State of the Co and Ni pure metal nanoparticles after CNT growth

In order to verify the state of the Co and Ni nanoparticles 5 after the entire CNT growth process, HRTEM was performed on CNTs 9 grown at 700°C for one minute. It is observed that interplanar distances measured in the particles (dₕₖₗ =0.204 nm) are in agreement with those characteristic of the Ni crystallographic structure (dₕₖₗ =0.203 nm). Embedded in the CNTs 9, the nanoparticles 5 remain pure metal after the entire CNT growth process. It is also observed that all the CNTs 9 are multi-wall CNTs. This was expected since the size of the nanoparticles 5 was too large for growing single wall CNTs. On the other hand, graphite walls are not defect free. However, this can be improved by tuning the growth parameters.

It will be appreciated that there are numerous variations and modifications possible on the processing methods as presented above. Accordingly, the processing methods and its related applications should not be deemed limited to the processing methods illustrated above. It is to be understood that although preferred embodiments, specific constructions and configurations, as well as materials, have been discussed herein for devices according to the present invention, various changes or modifications in form and detail may be made without departing from the scope and spirit of this invention.

## Claims

1. Method for forming catalyst nanoparticles (5) on a substrate (S), the method comprising:
- forming recesses (3) in the substrate (S) at predetermined locations, the recesses (3) having a bottom,
- providing catalyst nanoparticles (5, 6) onto the substrate (S), and
- selectively removing nanoparticles (6) provided at locations different from the bottom of the recesses (3).

2. Method according to claim 1, wherein providing nanoparticles (5, 6) onto the substrate (S) is performed by:
- providing at least one layer (4) of catalyst material onto the substrate (S) such that the catalyst material at least covers the bottom of the recesses (3), and
- breaking up the at least one layer (4) of catalyst material into nanoparticles (5, 6).

3. Method according to claim 2, wherein breaking up the at least one layer (4) of catalyst material is performed by a thermal and/or plasma assisted method.

4. Method according to claim 1, wherein providing nanoparticles (5, 6) onto the substrate (S) is performed by:
- depositing the nanoparticles (5, 6) onto the substrate (S) from a solution comprising the nanoparticles (5, 6) and a solvent, and
- after deposition of the nanoparticles (5, 6), removing the solvent.

5. Method according to claim 4, wherein removing the solvent is performed by evaporation.

6. Method according to any of the previous claims, wherein selectively removing nanoparticles (6) provided at locations different from the bottom of the recesses (3) is performed by:
- depositing a sacrificial material (7) onto the substrate (S) such that the sacrificial material (7) at least covers the nanoparticles (5) provided at the bottom of the recess (3),
- removing the nanoparticles (6) provided at locations different from the bottom of the recesses (3), and
- removing the sacrificial material (7).

7. Method according to claim 6, wherein removing the sacrificial material (7) is performed by performing a wet cleaning process.

8. Method according to claim 7, wherein the method furthermore comprises removing impurities (8) from edges of the recesses (3).

9. Method according to claim 8, wherein removing impurities (8) from edges of the recesses (3) is performed by immersing the substrate (S) in a 1:4 H₂SO₄:H₂O₂ solution for 5 minutes.

10. Method according to any of the previous claims, wherein forming recesses (3) in the substrate (S) at predetermined locations is performed by etching the recesses (3) in the substrate (S) at the predetermined locations.

11. Method according to claim 10, furthermore comprising, before etching, lithographically defining the predetermined locations on the substrate (S).

12. Method according to any of the previous claims, the substrate (S) comprising a base substrate (1), wherein forming recesses (3) in the substrate (S) at predetermined locations is performed by forming recesses (3) in the base substrate (1).

13. Method according to any of claims 1 to 12, the substrate (S) comprising a base substrate (1) and a dielectric layer (2), wherein forming recesses (3) in the substrate (S) at predetermined locations is performed by forming recesses (3) in the dielectric layer (2).

14. Use of the method according to any of the previous claims in a growth process of elongate nanostructures (9) on a substrate (S).

15. Method for forming elongate nanostructures (9) on a substrate (S), the method comprising:
- forming recesses (3) in the substrate (S) at predetermined locations, the recesses (3) having a bottom,
- providing catalyst nanoparticles (5, 6) onto the substrate (S),
- selectively removing nanoparticles (6) provided at locations different from the bottom of the recesses (3), and
- growing elongate nanostructures (9) in the recesses (3) using the nanoparticles (5) provided at the bottom of the recesses (3) as a catalyst.

16. Method according to claim 15, wherein providing nanoparticles (5, 6) onto the substrate (S) is performed by:
- providing at least one layer (4) of catalyst material onto the substrate (S) such that the catalyst material at least covers the bottom of the recesses (3), and
- breaking up the at least one layer (4) of catalyst material into nanoparticles (5, 6).

17. Method according to claim 16, wherein breaking up the at least one layer (4) of catalyst material is performed by a thermal and/or plasma assisted method.

18. Method according to claim 15, wherein providing nanoparticles (5, 6) onto the substrate (S) is performed by:
- depositing the nanoparticles (5, 6) onto the substrate (S) from a solution comprising the nanoparticles (5, 6) and a solvent, and
- after deposition, removing the solvent.

19. Method according to claim 18, wherein removing the solvent is performed by evaporation.

20. Method according to any of claims 15 to 19, wherein growing elongate nanostructures (9) is performed by a chemical vapour deposition process.

21. Method according to claim 20, wherein growing elongate nanostructures (9) comprises:
- providing a carbon source and an assistant gas, and
- growing elongate nanostructures (9) by heating the substrate (S).

22. Method according to claim 21, wherein growing elongate nanostructures (9) is performed by heating the substrate (S) to a temperature between 600°C and 800°C.

23. Method according to any of claims 15 to 22, wherein selectively removing nanoparticles (6) provided at locations different from the bottom of the recesses (3) is performed by:
- depositing a sacrificial material (7) onto the substrate (S) such that the sacrificial material (7) at least covers the nanoparticles (5) provided at the bottom of the recess (3),
- removing the nanoparticles (6) provided at locations different from the bottom of the recesses (3), and
- removing the sacrificial material (7).

24. Method according to any of claims 15 to 23, the substrate (S) comprising a base substrate (1), wherein forming recesses (3) in the substrate (S) at predetermined locations is performed by forming recesses (3) in the base substrate (1).

25. Method according to any of claims 15 to 23, the substrate (S) comprising a base substrate (1) and a dielectric layer (2), wherein forming recesses (3) in the substrate (S) at predetermined locations is performed by forming recesses (3) in the dielectric layer (2).

26. A method according to any of claims 15 to 25, wherein the growing elongate nanostructures (9) is performed by base growth.

27. A method according to any of claims 15 to 25, wherein the growing elongate nanostructures (9) is performed by tip growth.

28. Use of the method according to any of claims 15 to 27 in semiconductor processing.

29. Substrate provided with catalyst nanoparticles wherein the catalyst nanoparticles are selectively provided in recesses of the substrate.

30. Substrate provided with elongtae nanostructures wherein the elongate nanostuctures are selectively provided in recesses of the substrate.
